# EUROPEAN PATENT APPLICATION

(11) **EP 2 549 531 A1**
(43) Date of publication of application: **23.01.2013**
(21) Application number: 11174865.3
(22) Date of filing: 21.07.2011
(51) Int. Cl.: H01L 23/495

(54) **Lead frame for semiconductor device**

(71) Applicant: NXP B.V., 5656 AG Eindhoven (NL)
(72) Inventor: Yandoc, Ricardo, L, Redhil, Surrey RH1 1D (GB); Heyes, David, Redhill, Surrey RH1 1DL (GB); Lictao, Crispulo, E., Redhill, Surrey RH1 1DL (GB); Cacanindin, Wilson, Redhill, Surrey RH1 1DL (GB); Fenol, Florante, B., Redhill, Surrey RH1 1DL (GB)
(74) Representative: Crawford, Andrew

(57) **Abstract**

The present invention relates to lead frame for a semiconductor device and a semiconductor device comprising such a lead frame. The lead frame comprises a die mounting portion and a plurality of leads extending from the die mounting portion; wherein the leads further comprise a plurality of protrusions, said protrusions being arranged to grip a mould shutting strip.

## Description

### FIELD OF THE INVENTION

The present invention relates to a lead frame for a semiconductor device. The present invention also relates to a semiconductor device comprising such a lead frame.

### BACKGROUND OF THE INVENTION

The process of manufacturing completed semiconductor devices involves so called front-end operations, most notably for example formation of the semiconductor die (or chip) structure by epitaxial techniques. Following front-end operations, so called back-end operations involve placing the formed semiconductor die structure on a lead frame, electrically connecting the device contacts to external electrical connectors (also known as leads) on the lead frame, and packaging or encapsulating the structure to form the completed semiconductor device. For example external electrical connectors may be pins on an integrated circuit or leads on discrete devices such as MOSFET or Bipolar devices.

In semiconductor devices the encapsulation (or package) is used to protect the fragile die and wire bonds from damage by for example, chemicals and atmospheric water vapour, which can cause device failure. The encapsulation also provides the main body structure of a device and may allow for ease of transport and handling. Furthermore, the encapsulation determines a devices thermal and mechanical properties, and the packaging material and construction must be able to withstand high operating temperatures, particularly for high power devices.

Polymer encapsulations provide sufficient performance for applications where environmental conditions are less demanding, and also provide a low cost solution together with ease and speed of processing. This is particularly important for components used in surface mount technology, where low cost, high volume manufacturing are important. The polymer encapsulation process involves a compression moulding process and such processes are well known in the art of semiconductor manufacturing and for the sake of brevity they will not be discussed in any further detail here.

Under a compression pressure applied during the encapsulation moulding processes small amounts of the molten polymer encapsulation material can leak out between the sections of the mould resulting in a so-called 'flashing' or bleeding of polymer material onto the leads of a device. Polymer bleeds on semiconductor device leads are a major problem for device manufacturers because they significantly degrade the solderability of the leads and specifically for surface mount devices bleeds can cause misalignments between the printed circuit board (PCB) and can result in the device being tilted on the PCB. Furthermore, the flashes may fall-off during the process of mounting devices on to PCBs due to vibrations occurring during the device mounting process. The loose flash material can fall onto the solderable area of the PCB also causing the device to be partially or not to be soldered which can also result to package tilting on the PCB.

A known solution to the problem of flashing (or polymer bleeding) is simply to remove the unwanted polymer material from the leads after the moulding process has been completed. Removal methods can be chemical such as a chemical etch, or mechanically etching the polymer bleeds from the leads. However, such removal methods introduce a further processing step which can in turn add to the time and cost of producing devices.

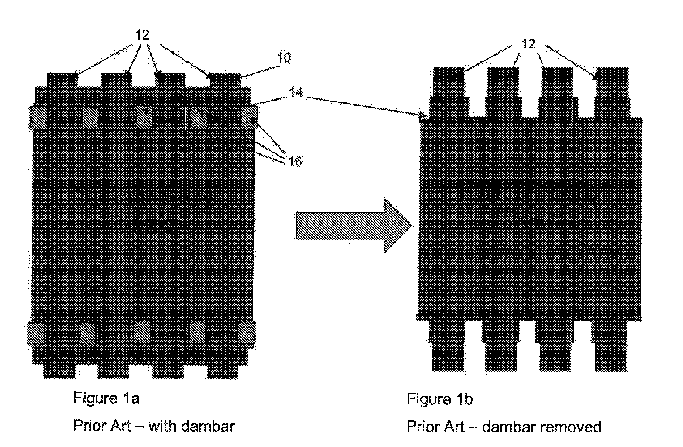

US Patent 6,853,057 describes the use of tie (or dam) bars in conjunction with mould shutting strips to prevent polymer bleeds during the encapsulation process. As illustrated generally in Figure 1a which shows mould shutting strips prior to removal following the encapsulation process, a dam bar 10 runs transversely between the leads 12 forming a cavity between the chamber, leads and chip mounting portion. Prior to the encapsulation process, mould shutting strips 16 are placed between the leads 12 and the dam bars. The purpose of the dam bar is twofold. Firstly, the dam bars hold the leads together during fabrication of the lead frame to ensure that lead coplanarity is maintained in the subsequent process steps, such as for example during encapsulation and forming/singulation of the completed device. Secondly, dam bars are used to support mould shutting strips 16 between the leads of the lead frame. The purpose of the mould shutting strips 16 is to prevent polymer bleeds from the mould press onto the lead frame during encapsulation process.

However, due to manufacturing tolerances it is not possible to produce mould shutting strips 16 which adequately prevent mould flashing on the leads. Specifically, it is not possible to produce mould shutting strips to accurately conform to and fill the space between the dam bar and adjacent leads due to different thermal expansion coefficients of the metals used for each of the dam bars, lead frames and mould shutting strips. For example, if the mould shutting strip is fabricated to exactly conform to the cavity, the leads will be pinched or deformed by the mould shutting strip due to cumulative tolerances of the leadframe resulting in unwanted metal burrs protruding along the leads. This can also result in loss of coplanarity of the leads. Furthermore exact conformity of the mould shutting strips can also result in difficulties in removing the mould shutting strips following the encapsulation process. Also due to the tolerances involved leadframe-to-mould cavity offset can occur between the mould shutting strips and the leads. Small amounts of resin bleeding from the mould press can therefore bleed on to the leads causing mould flashing. As shown in Figure 1b, following removal of the dam bars mould flashes remain on the leads.

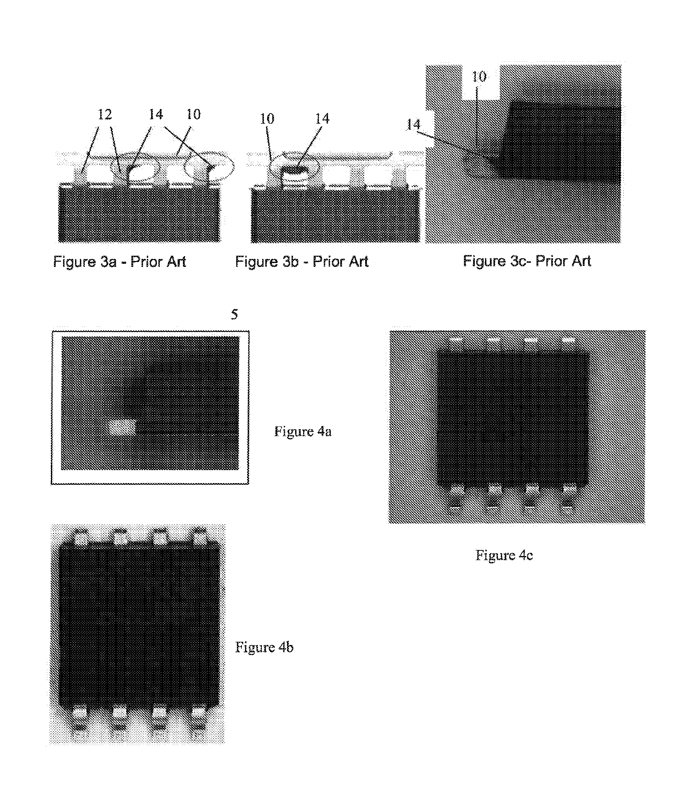

Figures 3a to 3c are images of a semiconductor device according to the prior art, flowing the moulding process and removal of the mould shutting strips. Figures 3a and 3b show the dam bar 10 in place. As can be clearly seen mould flashing 14 remains on the leads. As shown in Figure 3c, following removal of the dam bar mould flashing 14 also remains on the leads 12. The above mentioned problems may therefore be encountered for such a device.

### SUMMARY OF INVENTION

The present invention seeks to provide a lead frame for a semiconductor device which overcomes the above mentioned problems.

Thus, according to a first aspect of the invention there is provided a lead frame for a semiconductor device comprising a die mounting portion and a plurality of leads extending from the die mounting portion; wherein the leads further comprise a plurality of protrusions, wherein said protrusions are arranged to engageably grip mould shutting strips.

Preferably, the protrusions provide a barrier to mould flashing from the mould press during the encapsulation process, by holding the mould shutting strips in place there by providing resilient barrier to mould material leaking from the mould press and passing along the length of a lead. Preferably, the lead frame further comprises a tie bar extending transversely between the plurality leads. Preferably, the leads and the tie bar form a cavity between adjacent leads, said cavity being arranged to a receive said mould shutting strip. Preferably, said plurality of protrusion extends from the lead into the cavity by a distance of 0.03mm. This is particularly advantageous where silica is used in the polymer encapsulation material.

According to a second aspect of the invention there is provided a semiconductor device comprising a lead frame as set out in the first aspect.

### DESCRIPTION OF THE DRAWINGS

In the following discussion like reference numerals refer to like features. The invention will now described further hereinafter by way of example only with reference to the accompanying drawings in which:
Figures 1a and 1b are schematic views of the process flow of a conventional semiconductor device according to the prior art;
Figures 2a, 2b, 2c, and 2d are schematic views of the process flow of a semiconductor device according to an embodiment of the invention;
Figures 3a to 3c are images of a conventional semiconductor device according to the prior art;
Figures 4a and 4b are images of a semiconductor device according to an embodiment of the invention;
Figure 5a is a schematic view of a three terminal semiconductor device according to an embodiment of the invention;
Figure 5b is an exploded view of the detail A shown in Figure 5a;
Figure 5c is an exploded view of the detail B shown in Figure 5a;
Figure 5d is a schematic view of a ribbon of three terminal devices prior to singulation; and
Figure 6 is a schematic view of the arrangement of leads and a shutting strip.

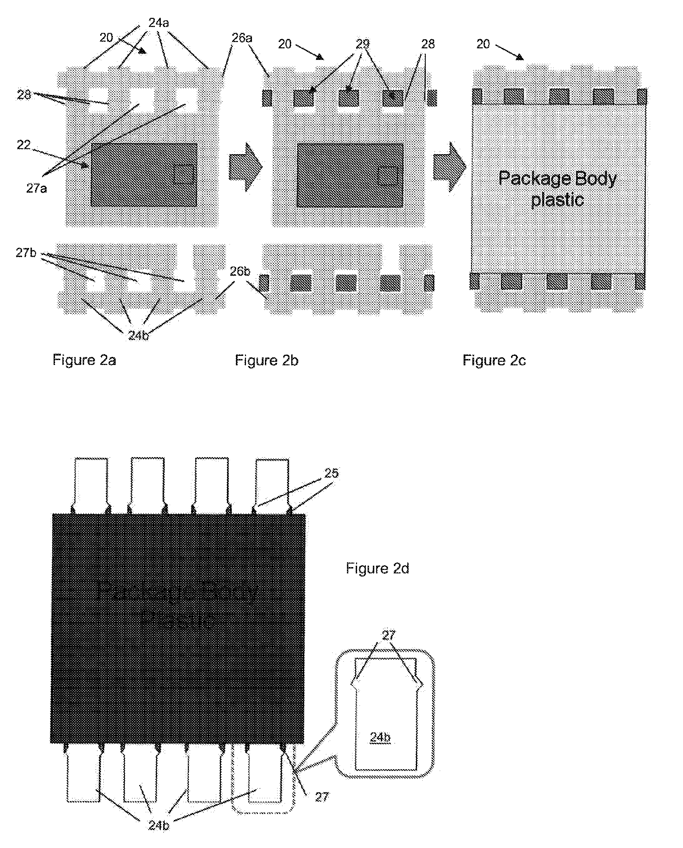

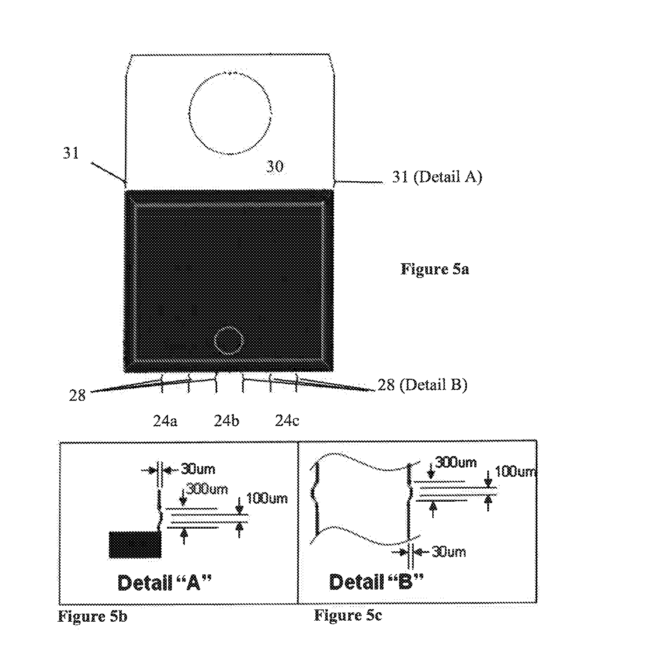

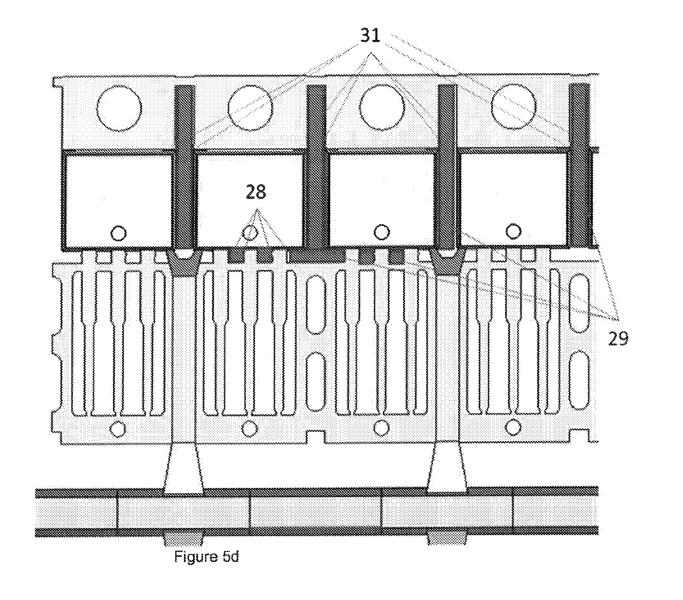

Referring to Figure 2a the lead frame 20 comprises a semiconductor die (or chip) mounting portion 22. Leads 24a, 24b are arranged on both sides of the chip mounting portion. In the present example, which is a DFN (dual flat no leads) arrangement, the lower leads 24b are separated from the chip mounting portion 22 during a process known as singulation, however for other standard device types the leads may extend from the chip mounting portion. The lead frame 20 can be formed from a copper/iron alloy. During moulding the lower leads 24b are held in place by the moulded package. The present example can therefore be described as a dual-in-line (DIL) lead frame because the leads are placed at opposing sides of the lead frame 20. The following discussion is also relevant to three lead or three terminal packages, such as a MOSFETor BJT as illustrated in Figure 5 and discussed in more detail below.

A first dam bar 26a extends between each of the leads 24a on a first side of the lead frame 20. Similarly, in the case of a DIL lead frame as illustrated in Figures 2a to 2c, a second dam bar 26b extends between each of the leads 24b on a second side of the lead frame 20. This arrangement of leads 24a, 24b and dam bars 26a, 26b results in cavities 27a, 27b between adjacent leads 24a, 24b on each side of the lead frame 20. The cavities 27a, 27b are arranged to receive mould shutting strips 29 which are inserted therein prior to the moulding step, as shown in Figure 2b. The mould shutting strips 29 can be formed from steel.

The leads 24a, 24b include protrusions 28, which act as an anti-mould flash feature, extending therefrom. The protrusions 28 extend from the leads into the cavities. In Figures 2b and 2c the protrusions are partially obscured by the in-situ mould shutting strips 29. The function of the protrusions 28 is two-fold. Firstly, the protrusions 28 are arranged to grip the mould shutting strips 29, thereby retaining the mould shutting strips in the cavities 27a, 27b during the encapsulation moulding process. Secondly, the protrusions 28 provide a maximum barrier to polymer bleeds leaking past the protrusions and along the length of the leads during the encapsulation moulding process. In this way the protrusions 28, in conjunction with the mould shutting strips 29 prevent polymer bleeds 25 from passing the point where the protrusions 28 extend from the leads, as shown in Figure 2d. The inset to Figure 2d shows an expanded view of an individual lead 24b showing two protrusions 28. As illustrated in Figure 2c, following the encapsulation moulding process the dam bars 26a and 26b and mould shutting strips 29 are removed to produce the final device as illustrated in Figure 2d. The process of removing the dam bars and mould shutting strips is well known in the art and for the sake of brevity will not be discussed herein. Whilst the above description relates to a DIL package it is also relevant to other package formations such as three terminal devices. Furthermore, the skilled person will appreciate that the invention can be applied to any package arrangement and is not specifically limited to three terminal or DIL packages.

In contrast to the prior art device shown in Figures 3a to 3c, the device shown Figures 4a to 4b employs the leadframe according to the present invention. It can be clearly seen the amount of mould flashing on the leads in Figures 4a to 4b is greatly reduced when compared to the prior art of Figures 3a to 3b.

Referring now to Figure 5a a three terminal device, such as a MOSFET or BJT is illustrated. The terminals (or leads) 24a, 24b, 24c, include protrusions 28 as discussed above. The function of the protrusions 28 is the same as that discussed above. Three terminal devices, particularly those used in high power applications can comprise a heat sink portion 30 to dissipate thermal energy. In this embodiment further protrusions 31 are provided on the heat sink portion 30. Figure 5d illustrates a so-called ribbon of such three terminal devices prior to singulation. The protrusions 31 (partially obscured by the mould shutting strips 29) are arranged to grip mould shutting strips 29 arranged in cavities between individual device. The function of the protrusions is as discussed above.

Figures 5b and 5c show the dimensions of the protrusions 28, 31 and are presented here as non-limiting examples. The skilled person will recognise that the dimensions shown are also applicable other lead frame arrangements.

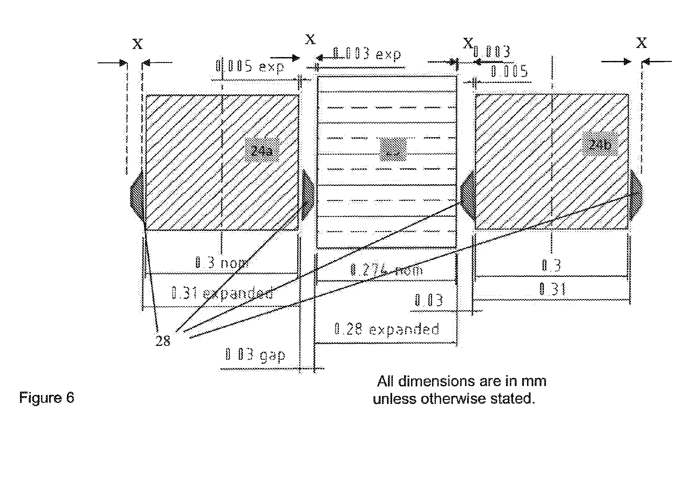

By way of non-limiting example, as illustrated in Figure 6, the width of an individual lead 24a, 24b is typically 0.3mm and the width of an individual shutting mould strip 29 is 0.274mm. In the illustrated example the width x of the protrusion (from the edge of the lead towards the shutting strip) is 0.03mm. It is well known in the art of semiconductor packaging to include silica in the polymer package material to protect against excessive thermal expansion in the packaged device. The width x of the protrusion 28 is therefore specifically chosen to be 0.03mm based on the 0.035mm minimum grain size of silica, such that silica based polymers cannot pass the protrusion 28. Therefore, the protrusions 28 provide a maximum barrier to polymer bleeds where the polymer contains silica.

Due to the elevated temperatures, typically in the range 170°C to 200°C used in the moulding process and due to thermal expansion the width of the mould shutting strip will, starting from the dimensions given above, typically expand to 0.28mm. Likewise, the width of each individual lead will expand to 0.31mm. Due to the expansion of the mould shutting strip 29 and leads 24a, 24b the shutting strip will more tightly gripped by a pair of opposing protrusions and thereby more tightly retain the mould shutting strip 29 in the cavities during the encapsulation moulding process. Furthermore, due to the expansion the probability of a gap occurring between the protrusion and the mould shutting strips will be reduced thereby providing a maximum barrier to polymer bleeds leaking past the protrusions and along the length of the leads during the package moulding process.

The above dimensions and temperatures are also applicable to other lead frame arrangements such as the three terminal device discussed above in relation to Figures 5a to 5c. Based on the foregoing description the skilled person will also recognise that the present invention may also be applied to all semiconductor device formations such as for example quad-flat no lead (QFN), Plastic Dual-In-line Package (PDIP), Power Quad Flat No Leads (PQFN), Small-Outline Integrated Circuit (SOIC), Thin Shrink Small Outline Package (TSSOP) and T0220.

Based on the foregoing description the skilled person will appreciate that more than two protrusions 28 may be arranged to extend into the cavity.

Any dimensions provided herein are given merely as an example. Based on the foregoing description the skilled person would recognise that alternative dimensions may be chosen depending specific lead frame and package configurations.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived there from. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A lead frame for a semiconductor device; comprising a die mounting portion and a plurality of leads extending from the die mounting portion; wherein
the leads further comprise a plurality of protrusions, said protrusions being arranged to grip a mould shutting strip.

2. The lead frame of claim 1, further arranged such that when said protrusions grip said mould shutting strips a barrier to the flow of a mould material is provided.

3. The lead frame of claims 1, further comprising a tie bar extending transversely between the plurality leads.

4. The lead frame of claims 1 and 2, wherein the leads and the tie bar form a cavity between adjacent leads, said cavity being arranged to a receive said mould shutting strip.

5. The lead frame of claim 4, wherein said plurality of protrusions extend into said cavity.

6. The lead frame of any preceding claim further comprising a heat sink portion, wherein the heat sink portion further comprises a plurality of protrusions, said protrusions being arranged to grip a mould shutting strip.

7. The lead frame of claim 1, wherein the width of each of said plurality of protrusions is less than the minimum grain size of silica.

8. The lead frame of claim 5, wherein each of said plurality of protrusions extend from the lead into the cavity by a distance of 0.03mm.

9. A semiconductor device comprising a lead frame as set out in any one of claims 1 to 6.
